(19) **Europäisches Patentamt**

**European Patent Office**

**Office européen des brevets**

(11) **EP 0 969 325 B1**

(12) **EUROPEAN PATENT SPECIFICATION**

(45) Date of publication and mention
of the grant of the patent:
**15.01.2003 Bulletin 2003/03**

(51) Int Cl.⁷: **G03F 7/20**, G03F 1/14,
H01J 37/317

(21) Application number: **99304777.8**

(22) Date of filing: **18.06.1999**

(54) **Lithographic projection apparatus**

Projektionsbelichtungsgerät

Appareil d'exposition par projection

(84) Designated Contracting States:
**DE FR GB IT NL**

(30) Priority: **01.07.1998 EP 98202191**

(43) Date of publication of application:
**05.01.2000 Bulletin 2000/01**

(73) Proprietor: **ASML Netherlands B.V.**
**5503 LA Veldhoven (NL)**

(72) Inventor: **Bleeker, Arno Jan**
**5615 LK Eindhoven (NL)**

(74) Representative: **Leeming, John Gerard**
**J.A. Kemp & Co.,**
**14 South Square,**
**Gray's Inn**
**London WC1R 5JJ (GB)**

(56) References cited:
**US-A- 4 227 090**     **US-A- 4 789 786**
**US-A- 4 939 373**     **US-A- 5 156 942**

## Description

The present invention relates to lithographic apparatus comprising:

a radiation system comprising a radiation source and an illumination system for supplying a projection beam of radiation;
a first movable object table provided with a mask holder for holding a mask;
a second movable object table provided with a substrate holder for holding a substrate; and
a projection system for imaging an irradiated portion of the mask onto a target portion of the substrate.

The invention particularly relates to such apparatus in which an image-bearing electromagnetic beam is used to generate an electron beam which exposes a radiation sensitive layer on a substrate.

For the sake of simplicity, the projection system may hereinafter be referred to as the "lens"; however, this term should be broadly interpreted as encompassing various types of projection system, including refractive optics, reflective optics, catadioptric systems, and charged particle optics, for example. The illumination system may also include elements operating according to any of these principles for directing, shaping or controlling the projection beam of radiation, and such elements may also be referred to below, collectively or singularly, as a "lens". In addition, the first and second object tables may be referred to as the "mask table" and the "substrate table", respectively. Further, the lithographic apparatus may be of a type having two or more mask tables and/or two or more substrate tables. In such "multiple stage" devices the additional tables may be used in parallel, or preparatory steps may be carried out on one or more stages while one or more other stages are being used for exposures. Twin stage lithographic apparatus are described in International Patent Applications WO 98/28665 and WO 98/40791, for example.

Lithographic projection apparatus can be used, for example, in the manufacture of integrated circuits (ICs). In such a case, the mask (reticle) may contain a circuit pattern corresponding to an individual layer of the IC, and this pattern can be imaged onto a target area (die) on a substrate (silicon wafer) which has been coated with a layer of photosensitive material (resist). In general, a single wafer will contain a whole network of adjacent dies which are successively irradiated via the reticle, one at a time. In one type of lithographic projection apparatus, each die is irradiated by exposing the entire reticle pattern onto the die in one go; such an apparatus is commonly referred to as a wafer stepper. In an alternative apparatus — which is commonly referred to as a step-and-scan apparatus — each die is irradiated by progressively scanning the reticle pattern under the projection beam in a given reference direction (the "scanning" direction) while synchronously scanning the wafer table parallel or anti-parallel to this direction; since, in general, the projection system will have a magnification factor M (generally < 1), the speed v at which the wafer table is scanned will be a factor M times that at which the reticle table is scanned. More information with regard to lithographic devices as here described can be gleaned from International Patent Application WO 97/33205.

In a lithographic apparatus, the size of features that can be imaged onto the wafer is limited by the wavelength of the projection radiation. To produce integrated circuits with a higher density of devices and hence higher operating speeds, it is desirable to be able to image smaller features. Whilst most current lithographic projection apparatus employ ultraviolet light generated by mercury lamps or excimer lasers, it has been proposed to use higher frequency (energy) radiation, e.g. X-rays or EUV, or particle beams, e.g. electrons or ions, as the illumination radiation in lithographic apparatus. However, electron and ion beam projection lithography devices that have been proposed have limited throughput because the total beam current must be limited to avoid stochastic (random) scattering effects. These effects are proportional to the field area, or the field area to the 3/4 power, and in one known system the total beam current is effectively limited to 35µA.

In known electron beam projection lithographic devices, the exposure field size is additionally limited because of the necessary mask structure and because of system aberrations (such as field curvature and distortion) that cannot be corrected by electron-optics. The two known methods of correcting aberrations in electron-optical systems employ foil lenses or line charges or currents on the axis of the system. In known lithography devices, foil lenses cause unacceptable scattering and beam attenuation, whilst the employed electron beam is too close to the axis to allow provision of a line charge or line current.

A hybrid optical/electron-beam lithography device has been proposed in US 5,156,942 and US 5,294,801. In this device, an ultraviolet (UV) beam is used to illuminate a mask, and an image of the mask is projected onto a photo-emmisive plate. The photo-emmisive plate is thereby caused to emit electrons in a pattern corresponding to that on the mask. The photo-electrons are accelerated and projected on the substrate wafer to expose a resist layer thereon.

According to the present invention there is provided a lithographic projection apparatus for imaging a mask pattern in a mask onto a substrate with a radiation sensitive layer, the apparatus comprising:

a radiation system comprising a radiation source and an illumination system for generating an illumination beam;
a first movable object table provided with a mask holder for holding a mask;
a second movable object table provided with a substrate holder for holding a substrate; and
a projection system for imaging irradiated portions of the mask onto target portions of the substrate, said projection system comprising:

a photo-cathode;
first projection means for projecting an electromagnetic radiation image of said mask onto said photo-cathode to cause emission of photo-electrons in a pattern corresponding to that of said mask; and
second projection means for projecting said photo-electrons onto a substrate; characterised in that:

said photo-cathode is curved to compensate for aberrations.

The present invention can therefore provide a hybrid optical/electron-beam lithography apparatus that has a higher throughput than conventional electron-beam devices. It can also have a larger field size whilst avoiding or reducing field aberrations of known hybrid devices.

The word "curved" as used with reference to the photo-cathode is intended to indicate that it is non-planar, i.e. that it is concave and/or convex with regard to the "optical axis" of the projection system.

Preferably the photo-cathode conforms to a part spherical surface.

According to the present invention there is also provided a device manufacturing method comprising the steps of:

providing a substrate which is at least partially covered by a layer of energy-sensitive material;
providing a mask containing a pattern;
using a beam of radiation to project at least part of the mask pattern onto a target area of the layer of energy-sensitive material;

characterized in that said step of projecting comprises the following steps;

irradiating the mask pattern with a beam of electromagnetic radiation to form an image-bearing electromagnetic radiation beam bearing an image of at least a part of said mask pattern;
directing said image-bearing electromagnetic onto a photocathode plate having a curved surface, so as to generate photo-electrons; and
directing said photo-electrons onto the target area of the substrate.

In a manufacturing process using a lithographic projection apparatus according to the invention a pattern in a mask is imaged onto a substrate which is at least partially covered by a layer of energy-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallisation, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target area", respectively.

The present invention will be described below with reference to exemplary embodiments and the accompanying schematic drawings, in which:

Figure 1 depicts a lithographic projection apparatus according to a first embodiment of the invention;
Figure 2 is a diagram of the projection system of the first embodiment of the invention; and
Figure 3 shows electron traces in a pseudo-monopole magnetic field.

In the various figures, like parts are indicated by like references.

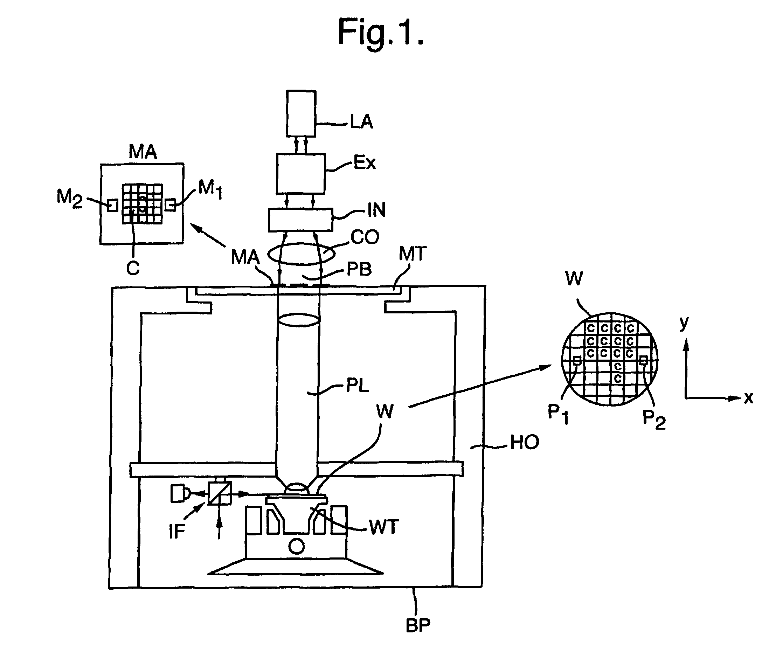

Figure 1 schematically depicts a lithographic projection apparatus according to the invention. The apparatus comprises:

• a radiation system LA, Ex, IN, CO for supplying a projection beam PB of radiation (e.g. UV radiation);
• a first object table (mask table) MT provided with a mask holder for holding a mask MA (e.g. a reticle), and connected to first positioning means for accurately positioning the mask with respect to item PL;

- a second object table (substrate table) WT provided with a substrate holder for holding a substrate W (*e. g.* a resist-coated silicon wafer), and connected to second positioning means for accurately positioning the substrate with respect to item PL;
- a projection system ("lens") PL for imaging an irradiated portion of the mask MA onto a target portion C (die) of the substrate W.

As here depicted, the whole apparatus comprises transmissive components; however, it may alternatively comprise one or more reflective components.

The radiation system comprises a source LA (*e.g.* a Hg lamp or excimer laser) which produces a beam of radiation. This beam is passed along various optical components, — *e.g.* beam shaping optics Ex, an integrator IN and a condenser CO — so that the resultant beam PB is substantially collimated and uniformly intense throughout its cross-section.

The beam PB subsequently intercepts the mask MA which is held in a mask holder on a mask table MT. Having passed through the mask MA, the beam PB passes through the lens PL, which focuses the beam PB onto a target area C of the substrate W. With the aid of the interferometric displacement and measuring means IF, the substrate table WT can be moved accurately, *e.g.* so as to position different target areas C in the path of the beam PB. Similarly, the first positioning means can be used to accurately position the mask MA with respect to the path of the beam PB, *e.g.* after mechanical retrieval of the mask MA from a mask library. In general, movement of the object tables MT, WT will be realized with the aid of a long stroke module (course positioning) and a short stroke module (fine positioning), which are not explicitly depicted in Figure 1.

The depicted apparatus can be used in two different modes:

- In step mode, the mask table MT is kept essentially stationary, and an entire mask image is projected in one go (*i.e.* a single "flash") onto a target area C. The substrate table WT is then shifted in the x and/ or y directions so that a different target area C can be irradiated by the beam PB;
- In scan mode, essentially the same scenario applies, except that a given target area C is not exposed in a single "flash". Instead, the mask table MT is movable in a given direction (the so-called "scan direction", *e.g.* the x direction) with a speed *v*, so that the projection beam PB is caused to scan over a mask image; concurrently, the substrate table WT is simultaneously moved in the same or opposite direction at a speed $V = Mv$, in which $M$ is the magnification of the lens PL (typically, $M = 1/4$ or 1/5). In this manner, a relatively large target area C can be exposed, without having to compromise on resolution.

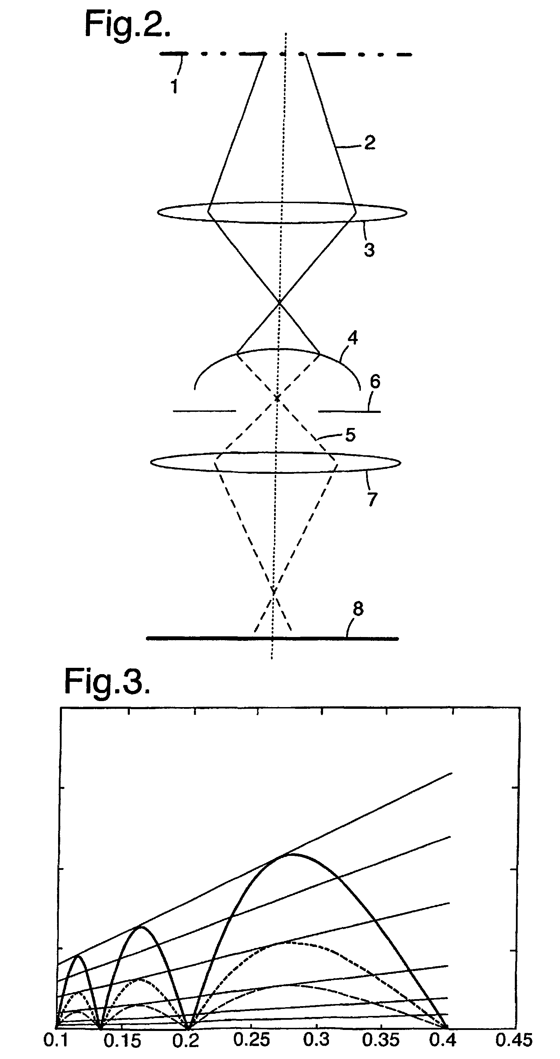

Figure 2 is a schematic diagram of the projection system PL of Figure 1. In this system, a conventional reticle 1 is illuminated by light (e.g. ultraviolet light of wavelength 248nm) source and illumination system LA, Ex, IN, CO. Light that has passed through transmissive regions of the reticle 1 is gathered into an image-bearing beam 2 by optical system 3 and projected onto a photocathode 4.

The optical system 3 is shown as a single lens for simplicity, but will in practice comprise multiple lenses and/or other components as required for focusing, demagnification (if desired) and correction of aberrations.

The photo-cathode 4 comprises a part spherical surface (made of glass or quartz, for example) which is coated with gold, gallium arsenide or carbide, for example. The particular coating employed determines the work function and efficiency of the photo-cathode 4. The coating(s) used may therefore vary according to the wavelength of the illumination light used in beam 2.

Photo-electrons 5 are emitted by the photocathode 4 in a pattern corresponding to that of the image projected on to it, are accelerated by acceleration plate 6 to about 100keV and are projected onto wafer 8 by electron-optical system 7. (In the case of a pseudo-monopole field (discussed below), an acceleration voltage as low as 2kV can be sufficient.) Again, the electron-optical system 7 is shown as a single lens but in practice will comprise appropriate electric and/or magnetic field generators, as discussed further below. The electron-optical system 7 may also de-magnify (e.g. with magnification 1/4) the image carried by the photo-electron beam 5 in projecting it onto the wafer 8.

The curvature of the photo-cathode 4 is calculated to correct for the curvature of the field of the electron-optical system. Other distortions can be corrected using the light optics prior to the photo-cathode 4.

When a photon of the illumination source strikes the photo-cathode, an electron is emitted in a random direction. The emitted electrons are accelerated by the electric field generated by the accelerator plate 6 and will follow parabolic paths, approaching the field lines asymptotically. If the paths of the electrons as they leave the accelerating field are extrapolated backwards, the electrons will appear to have come from a virtual source behind the photo-cathode.

Calculations suggest that the blur at the wafer caused by the random emission angles of the photoelectrons will be negligible if, with electrons having an energy spread of 1eV, the half-opening angle is constrained to 80 mrad at an accelerated energy of 10keV, and 800mrad at 100keV. Both cases assume an acceleration gap of 10mm. In practice, an energy spread of 0.2eV in the total system is expected, so the effect of the random emission angles can be neglected.

In a preferred embodiment of the invention, the accelerator takes the form of a plate with a central through-hole for the electrons to pass through. In order to reduce aberrations, it may be necessary to use an acceleration grid instead of an accelerator plate with a hole; however, such a grid would cast shadows on the substrate (wafer). An alternative is to use a "grillage", which comprises wires extending in only one direction. In this case the effect of the shadows can be avoided by scanning the mask and substrate relative to the grillage in the direction perpendicular to the wires of the grillage. The shadows cast by the grillage will then move across the substrate and will cause a negligible reduction in dose over the whole field, rather than local obstructions.

The photo-electron current generated by the incident light in beam 2 depends on quantum efficiency of the conversion and on wavelength, according to the following formula:

$$S(\lambda) = \frac{Y(\lambda).\lambda}{124}$$

where $S(\lambda)$, in units mA/Watt, is the electron current divided by the incident light power, $Y(\lambda)$ the quantum efficiency in %, and $\lambda$ the wavelength in nm. For a wavelength of 248nm, the quantum efficiency can be as high as 20%, giving a beam current of $60\mu A/mm^2$ from an incident light power of $150mW/cm^2$. This is ample current to provide a reasonable throughput, even if the quantum efficiency is reduced to 2%.

The present invention can employ a conventional electron-optical system comprising a telecentric system of two lenses. In this case, the photo-cathode is situated at the front focal plane of the first lens. The back focal plane of the first lens coincides with the front focal plane of the second lens. The substrate (wafer) is then positioned at the back focal plane of the second lens. With this arrangement, the magnification, M, equals f2/f1, where f1 and f2 are respectively the focal lengths of the first and second lenses. It is also possible to cancel most aberrations by making the lenses have identical shapes and excitations (Ampere-windings in the lens) but geometric dimensions scaled according to M. The most important aberration remaining is the field curvature, which can be corrected for by the curved photo-cathode of the invention. An existing electron-lithography device has a 23.5nm blur at the wafer due to field curvature and chromatic aberration. This can be substantially eliminated with the invention, allowing the field area on the wafer to be quadrupled and the maximum current increased by a factor of typically about 2.5 - 4. This results in a substantial increase in throughput.

The curved photo-cathode of the invention makes possible an alternative embodiment of the present invention in which the electron image is de-magnified onto the substrate (wafer) using a pseudo-monopole magnetic field. A magnetic monopole would generate a magnetic field in which the field lines are straight and come from one point, i.e. a magnetic field similar in form to the electric field generated by a point charge.

Whilst no magnetic monopoles are known to exist, it is possible to generate a magnetic field that approximates to a monopole field over a volume large enough to accommodate the electron beam and de-magnify it.

Because of the symmetry of the pseudo-monopole field, each field line can be considered an axis. In a sufficiently strong, rotationally symmetric field, an electron will always return to the axis from which it started. Thus with the pseudo-monopole field, the electrons will be confined to the field lines they crossed in their first gyration. Figure 3 illustrates this effect, showing electron traces of different starting (emission) angles confined to different field lines. In Figure 3, the horizontal axis represents distance along the optical axis of the projection system, and the vertical axis represents distance away from the optical axis, both in arbitrary units.

The pseudo-monopole field can therefore be arranged to guide the electrons to the wafer with the necessary de-magnification and without any increase in spherical or chromatic aberrations at each cross-over. The absence of a single global cross-over, as is present in a conventional de-magnifying system, means that the beam current is not limited by stochastic effects caused by the space charge at the cross-over. This therefore allows a further increase in total beam current of at least an order of magnitude compared with conventional systems. For example, a $3 \times 3mm^2$ emitting surface can be broken up into nine $1 \times 1mm^2$ sub-fields. The pseudo-monopole field presents each subfield with its own de-magnification lens. Thus a current nine times as large may be used without any increase in stochastic blur. The monopole field may be generated as described in, and with the apparatus of, US 5,268,579 (Bleeker), for example.

A further advantage of the system of the present invention is that it allows the use of line charges, or line currents if magnetic lenses are used, to correct aberrations in the electron-optics. In embodiments of the invention, if the part of the photo cathode that is illuminated is off-axis, then the relevant electron beam will also be off-axis, providing room for the line charge or line current.

Whilst we have described above a specific embodiment of the invention, it will be appreciated that the invention may be practiced otherwise than described. The description is not intended to limit the invention, which is defined by the scope of the appended claims.

## Claims

1. A lithographic projection apparatus for imaging a mask pattern in a mask onto a substrate with a radiation sensitive layer, the apparatus comprising:

a radiation system comprising a radiation source and an illumination system for generating an illumination beam;

a first movable object table provided with a mask holder for holding a mask;
a second movable object table provided with a substrate holder for holding a substrate; and
a projection system for imaging irradiated portions of the mask onto target portions of the substrate, said projection system comprising:

a photo-cathode;
first projection means for projecting an electromagnetic radiation image of said mask onto said photo-cathode to cause emission of photo-electrons in a pattern corresponding to that of said mask; and
second projection means for projecting said photo-electrons onto a substrate;

**characterised in that**:

said photo-cathode is curved to compensate for aberrations.

2. An apparatus according to claim 1 wherein said photo-cathode has a curved form adapted to compensate for field aberrations of said second projection means.

3. An apparatus according to claim 1 or 2 wherein said photo-cathode substantially conforms to a part-spherical surface.

4. An apparatus according to claim 1, 2 or 3 wherein said second projection means comprise electron-accelerator means and electron-focusing means.

5. An apparatus according to claim 4 wherein said electron-focusing means comprise means for generating a pseudo-monopole magnetic field.

6. An apparatus according to claim 4 or 5 wherein said electron-accelerator means comprise a grillage of wires extending in substantially one direction only.

7. An apparatus according to claim 6 further comprising means for
scanning said mask and substrate relative to said grillage.

8. An apparatus according to any one of the preceding claims wherein said first projection means is adapted to pre-compensate for distortions in the second projection means by causing counteracting distortions in said electromagnetic radiation image.

9. An apparatus according to any one of the preceding claims wherein
said electromagnetic radiation comprises ultraviolet radiation.

10. An apparatus according to any one of the preceding claims wherein
said second projection means is adapted to project a de-magnified electron image onto said substrate.

11. A device manufacturing method comprising the steps of:

providing a substrate which is at least partially covered by a layer of energy-sensitive material;
providing a mask containing a pattern;
using a beam of radiation to project at least part of the mask pattern onto a target area of the layer of energy-sensitive material;

**characterized in that** said step of projecting comprises the following steps;

irradiating the mask pattern with a beam of electromagnetic radiation to form an image-bearing electromagnetic radiation beam bearing an image of at least a part of said mask pattern;
directing said image-bearing electromagnetic onto a photocathode plate having a curved surface, so as to generate photo-electrons; and
directing said photo-electrons onto the target area of the substrate.

12. A device manufactured according to the method of claim 11.

**Patentansprüche**

1. Lithografische Projektionsvorrichtung zum Abbilden eines Maskenmusters einer Maske auf ein Substrat mit einer strahlungsempfindlichen Schicht, wobei die Vorrichtung umfasst:

ein Strahlungssystem mit einer Strahlungsquelle und einem Belichtungssystem zum Erzeugen eines Belichtungsstrahls;
einen ersten beweglichen Objekttisch mit einem Maskenhalter zum Halten eine Maske;
einen zweiten beweglichen Objekttisch mit einem Substrathalter zum Halten eines Substrats; und
ein Projektionssystem zum Abbilden beleuchteter Abschnitte der Maske auf Zielabschnitte des Substrats, wobei das Projektionssystem umfasst:

eine Fotokathode;
ein erstes Projektionsmittel zum Projizieren eines elektromagnetischen Strahlungsbildes der Maske auf die Fotokathode, um die Emission von Fotoelektronen in einem Muster, das dem der Maske entspricht, anzuregen; und
ein zweites Projektionsmittel zum Projizieren der Fotoelektronen auf ein Substrat;

**dadurch gekennzeichnet, dass**
die Fotokathode gekrümmt ist, um Aberrationen zu kompensieren.

2. Vorrichtung nach Anspruch 1, wobei die Fotokathode eine gekrümmte Form hat, die geeignet ist Feldaberrationen des zweiten Projektionsmittels zu kompensieren.

3. Vorrichtung gemäß Anspruch 1 oder 2, wobei die Fotokathode im Wesentlichen einer teilsphärischen Oberfläche entspricht.

4. Vorrichtung nach Anspruch 1, 2 oder 3, wobei das zweite Projektionsmittel ein Elektronenbeschleunigungsmittel und einen Elektronenfokussiermittel umfasst.

5. Vorrichtung nach Anspruch 4, wobei das Elektronenfokussiermittel ein Mittel zum Erzeugen eines Pseudomonopolmagnetfeldes umfasst.

6. Vorrichtung nach Anspruch 4 oder 5, wobei das Elektronenbeschleunigungsmittel einen Rost von Drähten, die sich im Wesentlichen nur in einer Richtung ausdehnen, umfasst.

7. Vorrichtung nach Anspruch 6, die weiter Mittel zum Abtasten der Maske und des Substrats relativ zu dem Rost umfasst.

8. Vorrichtung nach einen der voherrgehenden Ansprüche, wobei das erste Projektionsmittel geeignet ist, Verzerrungen des zweiten Projektionsmittels vorzukompensieren, indem es gegenwirkende Verzerrungen in dem elektromagnetischen Strahlungsbild erzeugt.

9. Vorrichtung nach einem der vorhergehenden Ansprüche, wobei die elektromagnetische Strahlung ultraviolette Strahlung umfasst.

10. Vorrichtung nach einem der vorhergehenden Ansprüche, wobei das zweite Projektionsmittel geeignet ist ein verkleinertes Elektronenbild auf das Substrat zu projizieren.

11. Verfahren zum Herstellen einer Vorrichtung mit den Schritten:

Bereitstellen eines Substrats, das wenigstens teilweise mit einer Schicht energiesensitiven Materials beschichtet ist;

Bereitstellen einer Maske mit einem Muster;
Verwenden eines Strahl zum projizieren wenigstens eines Teils des Maskenmusters auf einen Zielbereich der Schicht des energiesensitiven Materials;

**dadurch gekennzeichnet, dass**
der Schritt des Projizierens die folgenden Schritte umfasst;
ein Beleuchten des Maskenmusters mit einem Strahl elektromagnetischer Strahlung um einen bildtragenden elektromagnetischen Strahl mit einem Bild wenigstens eines Teils des Maskenmusters zu erzeugen;
ein Richten des bildtragenden elektromagnetischen Strahls auf eine Fotokathodenplatte mit einer gekrümmten Oberfläche um Fotoelektronen zu erzeugen; und
ein Richten der Fotoelektronen auf den Zielbereich des Substrats.

12. Vorrichtung, die mit dem Verfahren des Anspruchs 11 erzeugt wurde.

**Revendications**

1. Appareil de projection lithographique pour représenter un motif de masque dans un masque sur un substrat ayant une couche sensible au rayonnement, l'appareil comportant :

un système de rayonnement comportant une source de rayonnement et un système d'illumination pour produire un faisceau d'illumination;
une première table d'objet mobile munie d'un support de masque pour supporter un masque;
une seconde table d'objet mobile munie d'un support de substrat pour supporter un substrat; et
un système de projection pour représenter des parties irradiées du masque sur des parties cible du substrat, ledit système de projection comportant :

une photocathode;
des premiers moyens de projection pour projeter une image de rayonnement électromagnétique dudit masque sur ladite photocathode pour provoquer une émission de photo-électrons selon un motif correspondant à celui dudit masque; et
des seconds moyens de projection pour projeter lesdits photo-électrons sur un substrat;

**caractérisé en ce que** :

ladite photocathode est incurvée pour compenser des aberrations.

2. Appareil selon la revendication 1, dans lequel ladite photocathode a une forme incurvée adaptée pour compenser des aberrations de champ desdits seconds moyens de projection.

3. Appareil selon la revendication 1 ou 2, dans lequel ladite photocathode se conforme essentiellement à une surface sphérique partielle.

4. Appareil selon la revendication 1, 2 ou 3, dans lequel lesdits seconds moyens de projection comportent des moyens accélérateurs d'électrons et des moyens de focalisation d'électrons.

5. Appareil selon la revendication 4, dans lequel lesdits moyens de focalisation d'électrons comportent des moyens pour produire un champ magnétique pseudomonopolaire.

6. Appareil selon la revendication 4 ou 5, dans lequel lesdits moyens accélérateurs d'électrons comportent un grillage de fils s'étendant essentiellement dans une seule direction.

7. Appareil selon la revendication 6, comportant de plus des moyens pour balayer ledit masque et ledit substrat par rapport audit grillage.

8. Appareil selon l'une quelconque des revendications précédentes, dans lequel lesdits premiers moyens de projection sont adaptés pour précompenser des distorsions dans les seconds moyens de projection en provoquant des distorsions antagonistes dans ladite image de rayonnement électromagnétique.

9. Appareil selon l'une quelconque des revendications précédentes, dans lequel ledit rayonnement électromagnétique comporte un rayonnement ultraviolet.

10. Appareil selon l'une quelconque des revendications précédentes, dans lequel lesdits seconds moyens de projection sont adaptés pour projeter une image d'électrons réduite sur ledit substrat.

11. Procédé de fabrication de dispositif comportant les étapes consistant à :

prévoir un substrat qui est au moins partiellement recouvert d'une couche d'un matériau sensible à une énergie;
prévoir un masque contenant un motif;
utiliser un faisceau de rayonnement pour projeter au moins une partie du motif de masque sur une zone cible de la couche de matériau sensible à une énergie;

**caractérisé en ce que** ladite étape de projection comporte les étapes suivantes;
irradier le motif de masque à l'aide d'un faisceau de rayonnement électromagnétique pour former un faisceau de rayonnement électromagnétique porteur d'image portant une image d'au moins une partie dudit motif de masque;
diriger ledit faisceau électromagnétique porteur d'image sur une plaque de photocathode ayant une surface incurvée, de manière à produire des photo-électrons; et
diriger lesdits photo-électrons sur la zone cible du substrat.

12. Dispositif fabriqué selon le procédé de la revendication 11.

# Fig.1.

# Fig.2.

# Fig.3.